# EUROPEAN PATENT APPLICATION

(11) **EP 4 686 375 A1**
(43) Date of publication of application: **28.01.2026**
(21) Application number: 25190985.9
(22) Date of filing: 22.07.2025
(51) Int. Cl.: H10P 50/24

(54) **ETCHING BY ELECTRON ENHANCED PROCESSES WITH POSITIVE SUBSTRATE VOLTAGE**

(30) Priority: 23.07.2024 US 202463674633 P; 21.07.2025 US 202519275028
(71) Applicant: Samsung Electronics Co., Ltd., Suwon-si, Gyeonggi-do 16677 (KR); The Regents of the University of Colorado, a body corporate, Denver, CO 80203 (US)
(72) Inventor: YASMEEN, Sumaira, Denver, CO, 80203 (US); GEORGE, Steven, Denver, CO, 80203 (US); SIMKA, Harsono, San Jose, CA, 95134 (US)
(74) Representative: Kuhnen & Wacker Patent- und Rechtsanwaltsbüro PartG mbB

(57) **Abstract**

A method for etching a thin film includes conducting electron-enhanced chemical vapor etching with at least one reactive background gas and electrons to etch a thin film on a substrate with a positive substrate voltage. In an embodiment, the method is a method for etching a silicon thin film, including conducting electron-enhanced chemical vapor etching with at least one reactive background gas and electrons to etch a silicon thin film on a substrate with a positive substrate voltage.

## Description

### BACKGROUND

### 1. Field

Embodiments of the present disclosure relate to processes for electron-enhanced chemical vapor etching (EE-CVE).

### 2. Description of the Related Art

Device dimensions need to be controlled at the atomic level for a variety of cutting-edge technologies, including the fabrication of abrupt heterostructure interfaces, extremely thin layers for optoelectronics, quantum devices, and nanostructures. This precision is crucial for achieving the monolayer accuracy required in both film deposition and etching processes. While techniques for depositing solid materials one atomic layer at a time have been successfully developed, achieving the same precision in etching processes remains a significant challenge.

In particular, Si, the premier electronic material, has proven difficult to etch with atomic layer precision. Although significant progress has been made with materials such as GaAs, where methods like Cl₂/Cl gas and low-energy Ar⁺ ion bombardment, energetic electron bombardment, and KrF excimer laser irradiation have been successful, similar control in silicon etching has been elusive.

Previous studies on silicon etching, such as those using F atoms and Ar⁺ ion bombardment, revealed a saturation etch rate dependent on the F atom concentration and the exposure time to F atoms. These studies indicated that achieving self-limiting etching was not possible. Further research using molecular chlorine and Ar⁺ ion bombardment showed a saturation etch rate with increased ion irradiation time, but the rate was limited to only 1/3 monolayer per cycle for Si(100).

The process was further developed, and Si was etched using thermal atomic layer etching (ALE) process. However, thermal ALE of silicon faces several significant challenges. Achieving uniform etch rates across the surface is difficult due to variations in surface morphology and local temperature fluctuations. Surface contamination from residual gases or impurities can inhibit chemisorption of etching precursors, leading to uneven etching. The high thermal budget required for the process can introduce stress and damage to the silicon substrate. Efficient removal of reaction byproducts is essential to prevent defects and non-uniform etching. Selecting suitable precursors that facilitate desired reactions without causing side reactions is challenging, and ensuring process control and repeatability is critical. Additionally, minimizing substrate damage while achieving the desired etch rate remains a delicate balance.

In view of the above, there is a need in the art for an improved method for etching films.

Information disclosed in this Background section has already been known to the inventors before achieving the disclosure of the present application or is technical information acquired in the process of achieving the disclosure. Therefore, it may contain information that does not form the prior art that is already known to the public.

### SUMMARY

It is an object of the present disclosure to provide an improved method for etching films.

To meet the above and other objects, the present disclosure employs EE-CVE (Electron-Enhanced Chemical Vapor Etching), which involves the use of electrons to enable controlled vapor etch of a material using chemical reactions using simple gases, without thermal or direct plasma activations. An example is EE-CVE of Si.

This process allows for etching of films of group IV materials such as Si: (i) at low temperatures, such that the process is back-end-of-line (BEOL) compatible; (ii) without direct plasma (no energetic ions created, hence low damage); and (iii) without the use of corrosive gases (F₂, HF, CF₄, SO₂, etc.).

Innovative aspects include: electrons (specially tuned) are new reactants, activating gas-phase species near the surface, enabling etch reactions that do not occur unless at high temperature or in plasma. For example, an electron-mediated process is provided that activates H₂ molecules, creating H- (anions) and H radicals near the surface.

Applications can include, e.g., Logic 3DSFET, 3D DRAM, and NAND.

In view of the above, EE-CVE uses electrons to enable the etching of films (e.g., Si) on a substrate, without requiring ion bombardment (in a direct plasma) and corrosive gases (typically halogen containing molecules). The process involves the use of a reactive background gas, such as hydrogen (H₂), and electrons. The electrons are used to dissociate the background gas molecules and create reactive species that can react with the film to be etched. Some electrons are reflected after collisions with the surface, with a lower energy than the incoming electron energy. These are secondary electrons. A positive substrate bias is used to attract the secondary electrons to the surface, hence improving the effectiveness of the reactions with the reactive background gas.

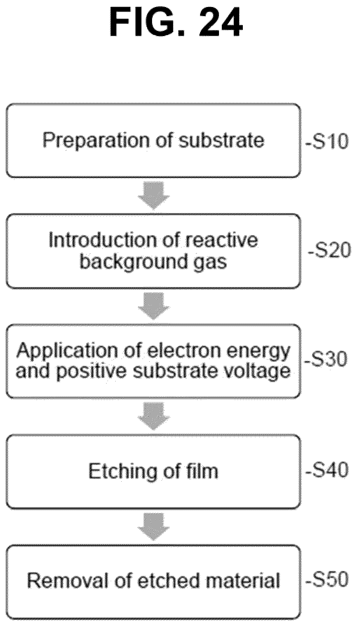

Aspects of the process of the present disclosure may include (1) preparation of the substrate, (2) introduction of the reactive background gas, (3) application of electron energy, (4) etching of the film, and (5) removal of etched material, as shown in the flow chart set forth in FIG. 24 and as further described in the following:
(1) Preparation of the substrate (Step S10): The substrate is typically a silicon wafer, which is cleaned and dried to ensure a smooth surface for etching. It should be noted the present disclosure is not limited to a substrate for etching that is pure silicon. Rather, the EE-CVE technique for etching Si applies to many substrates, including Si, dielectrics, metals, etc. One of the benefits of EE-CVE is to enable etching of substrates that cannot be etched by conventional techniques.
(2) Introduction of the reactive background gas (Step S20): The reactive background gas used in EE-CVE is typically hydrogen (H₂), which helps to enhance the dissociation of the gas and create reactive species.
(3) Application of electron energy (Step S30): Electron energy is applied to the reaction chamber using an electron gun or other device (such as hollow-cathode source), which enables the dissociation of the gas and create reactive species.
(4) Etching of the film (Step S40): The reactive species react with the film to be etched, removing material from the surface and creating a pattern or structure.
(5) Removal of etched material (Step S50): The etched material is removed from the reaction chamber, leaving behind a pattern or structure on the substrate.

Thus, the present disclosure provides a number of embodiments, including the following.

A first embodiment of the present disclosure includes a method for electron-enhanced chemical vapor etching of a film, including: cleaning and drying a substrate having a film thereon; introducing a reactive background gas into a reaction chamber containing the substrate; applying electrons to the reaction chamber to dissociate the reactive background gas and create reactive species; etching the film on the substrate by reacting the reactive species with the film, wherein the substrate has a positive substrate voltage, and removing etched material from the reaction chamber, leaving behind a pattern or structure on the substrate.

A second embodiment of the present disclosure includes a method of the first embodiment, wherein the film is an amorphous silicon film.

A third embodiment of the present disclosure includes a method of the first embodiment, wherein the film is a crystalline silicon film.

A fourth embodiment of the present disclosure includes a method of the first embodiment, wherein the film is a germanium film.

A fifth embodiment of the present disclosure includes a method of the first embodiment, wherein the film is a silicon germanium film.

A sixth embodiment of the present disclosure includes a method of the fifth embodiment, wherein the silicon germanium is SiₓGe₁₋ₓ, wherein 0.15≤x≤0.85.

A seventh embodiment of the present disclosure includes a method of the fifth embodiment, wherein the silicon germanium is SiₓGe₁₋ₓ, wherein 0.85<x<1.

An eighth embodiment of the present disclosure includes a method of the first embodiment, wherein the substrate having a film thereon is (i) a silicon dioxide substrate having a silicon film thereon or (ii) a silicon nitride substrate having a silicon film thereon.

A ninth embodiment of the present disclosure includes a method of the first embodiment, wherein the reactive background gas is hydrogen.

A tenth embodiment of the present disclosure includes a method of the second embodiment, wherein the reactive background gas is hydrogen.

An eleventh embodiment of the present disclosure includes a method of the third embodiment, wherein the reactive background gas is hydrogen.

A twelfth embodiment of the present disclosure includes a method of the first embodiment, wherein the etching is conducted at a temperature of 15°C to 28°C.

A thirteenth embodiment of the present disclosure includes a method of the second embodiment, wherein the etching is conducted at a temperature of 15°C to 28°C.

A fourteenth embodiment of the present disclosure includes a method of the third embodiment, wherein the etching is conducted at a temperature of 15°C to 28°C.

A fifteenth embodiment of the present disclosure includes a method of the first embodiment, wherein the positive substrate voltage is up to 100 V.

A sixteenth embodiment of the present disclosure includes a method of the second embodiment, wherein the positive substrate voltage is up to 100 V.

A seventeenth embodiment of the present disclosure includes a method of the third embodiment, wherein the positive substrate voltage is up to 100 V.

An eighteenth embodiment of the present disclosure includes a method of the first embodiment, wherein the reactive background gas is at a pressure of <3 mTorr.

A nineteenth embodiment of the present disclosure includes a method of the first embodiment, wherein the electrons have an electron energy of 100 eV to 150 eV.

A twentieth embodiment of the present disclosure includes a method of the first embodiment, wherein the electrons are generated by a hollow cathode plasma electron source.

### BRIEF DESCRIPTION OF DRAWINGS

The patent or application file contains at least one drawing executed in color. Copies of this patent or patent application publication with color drawing(s) will be provided by the Office upon request and payment of the necessary fee.

Example embodiments of the present disclosure will be more clearly understood from the following detailed description taken in conjunction with the accompanying drawings in which:
FIG. 1 shows the applicability of the presently disclosed electron-enhanced chemical vapor etching process to compound semiconductors in addition to elemental semiconductors.
FIG. 2 shows a diagram of one embodiment of the presently disclosed electron-enhanced chemical vapor etching process.
FIG. 3 is a schematic diagram showing a V-shaped reactor with a hollow cathode plasma electron source above the sample at the center of the V, wherein spectroscopic ellipsometry connects to the two ends of the V, and pumping ports to either a mechanical pump or turbomolecular pump connect through the 4-way cross.
FIG. 4 is a diagram of the hollow cathode operation in an embodiment of the present disclosure.
FIG. 5 shows increasing collimating coil current, which is a parameter that can affect electron enhanced processes.
FIG. 6 is a schematic diagram showing the hollow cathode generating primary electrons in an embodiment of the present disclosure.
FIG. 7 shows various pathways for electron-enhanced processing in an embodiment of the present disclosure.
FIG. 8 is a schematic diagram illustrating the Si EE-CVE process in which electrons and H₂ RBG are continuously introduced into the chamber.
FIG. 9 is a graph showing the change in etch thickness vs time of Si EE-CVE with and without the application of sample bias.
FIGS. 10A and 10B show the process schematic for Si EE-CVE in the absence and presence of positive sample bias, respectively..
FIGS. 11A and 11B show schematic diagrams for the Si EE-CVE process for electron pulses and continuous electrons, and FIG. 11C shows the etch thickness of Si (100) with time.
FIGS. 12A-12D show the EE-CVE results for a-Si (FIG. 12A), c-Si (FIG. 12B), SiGe (FIG. 12C), and c-Ge (FIG. 12D) under different grid bias voltages, while keeping the rest of the conditions constant .
FIGS. 13A and 13B show the etch selectivity of various substrates at 100 V of grid according to an embodiment of the present disclosure.
FIGS. 14A-14D show the EE-CVE results for a-Si (FIG. 14A), c-Si (FIG. 14B), SiGe (FIG. 14C), and c-Ge (FIG. 14D) when keeping the grid bias voltage constant to 50 V and increasing the H₂ RBG flux.
FIGS. 15A-15C respectively show the AFM roughness of (a) pristine silicon-on-insulator (SOI) wafer; (b) EE-CVD grown Si film (10 nm); and (c) the same Si EE-CVD film after etching.
FIGS. 16A-16C show the etching of Si using EE-CVE through a stainless-steel mesh mask.
FIG. 17 shows the Si EE-CVE using D₂ at 3 sccm and 7 sccm of D₂.
FIG. 18 shows an exemplary embodiment of the present disclosure for Si EE-CVE with increasing bias grid voltage.
FIG. 19 shows the effect of H₂ flow rate on Si(100) EE-CVE with H₂ for an exemplary embodiment of the present disclosure.
FIG. 20 shows the effect of H₂ flow rate on SiGe EE-CVE with H₂ for an exemplary embodiment of the present disclosure.
FIG. 21 shows the effect of grid bias on Ge EE-CVE with H₂ for an exemplary embodiment of the present disclosure.
FIG. 22 is a graph showing etching of amorphous silicon at different positive sample voltages vs. time for an exemplary embodiment of the present disclosure.
FIG. 23 is a schematic for electron-enhanced Si etching with H₂ reactive background gas for an exemplary embodiment of the present disclosure.
FIG. 24 is a flow chart showing the method steps for an exemplary embodiment of the present disclosure.

### DETAILED DESCRIPTION OF EXAMPLE EMBODIMENTS

The embodiments of the disclosure described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof. In addition, it should be understood that all descriptions of principles, aspects, examples, and embodiments of the disclosure are intended to encompass structural and functional equivalents thereof. In addition, these equivalents should be understood as including not only currently well-known equivalents but also equivalents to be developed in the future.

Throughout this disclosure, values expressed in a range format should be interpreted in a flexible manner to include not only the numerical values explicitly recited as the limits of the range, but also to include all the individual numerical values or sub-ranges encompassed within that range as if each numerical value and sub-range is explicitly recited. For example, a range of "about 0.1% to about 5%" or "about 0.1% to 5%" should be interpreted to include not just about 0.1% to about 5%, but also the individual values (e.g., 1%, 2%, 3%, and 4%) and the sub-ranges (e.g., 0.1% to 0.5%, 1.1% to 2.2%, 3.3% to 4.4%) within the indicated range. The statement "about X to Y" has the same meaning as "about X to about Y," unless indicated otherwise. Likewise, the statement "about X, Y, or about Z" has the same meaning as "about X, about Y, or about Z," unless indicated otherwise.

In this disclosure, the terms "a," "an," or "the" are used to include one or more than one unless the context clearly dictates otherwise. The term "or" is used to refer to a nonexclusive "or" unless otherwise indicated. The statement "at least one of A and B" or "at least one of A or B" has the same meaning as "A, B, or A and B." In addition, it is to be understood that the phraseology or terminology employed herein, and not otherwise defined, is for the purpose of description only and not of limitation. Any use of section headings is intended to aid reading of the document and is not to be interpreted as limiting; information that is relevant to a section heading may occur within or outside of that particular section.

In the methods described herein, the acts can be carried out in any order, except when a temporal or operational sequence is explicitly recited. Furthermore, specified acts can be carried out concurrently unless explicit claim language recites that they be carried out separately. For example, a claimed act of doing X and a claimed act of doing Y can be conducted simultaneously within a single operation, and the resulting process will fall within the literal scope of the claimed process.

As used herein, unless defined otherwise, all technical and scientific terms generally have the same meaning as commonly understood by one of ordinary skill in the art to which this disclosure belongs. Generally, the nomenclature used herein and the laboratory procedures in surface chemistry are those well-known and commonly employed in the art.

The term "about" as used herein can allow for a degree of variability in a value or range, for example, within 10%, within 5%, or within 1% of a stated value or of a stated limit of a range, and includes the exact stated value or range.

As used herein, the term "CVE" refers to chemical vapor etching, which is a method for etching films, including thin films. In certain embodiments, the term "thin" refers to a range of thickness from about 0.1 nm to about 300 nm, or more particularly, 0.1 nm to 300 nm. The method of the present disclosure can also etch thicker films, such as those having thicknesses on the order of microns or even millimeters.

The present disclosure employs electron-enhanced etching, which leverages the energy and precision of electron beams to achieve finer control over the etching process. This method involves the use of an electron beam to induce localized chemical reactions on the silicon surface, enabling highly controlled and selective material removal. That is, EE-CVE of the present disclosure works by using electrons to enhance the dissociation of, e.g., hydrogen molecules into hydrogen radicals and anions. These radicals and anions then react with, e.g., silicon atoms at room temperature producing volatile silane compounds which desorb from surface, thus effectively removing the silicon layer through chemical reaction. It is possible achieve high aspect ratio structures without generating significant heat damage to surrounding material properties. Also, the present disclosure involves low thermal budget requirements compared to other methods currently available in the industry.

In particular, this disclosure concerns electron-enhanced etching of, e.g., silicon, focusing on its potential to provide the accuracy and control needed for next-generation electronic devices. The process further concerns the role of secondary electrons and dissociative electron attachment during the etch process. Etching was observed for various substrates such as crystalline Si(100), amorphous Si (Si film grown using the EE-CVD technique), SiGe and Ge (100).

One advantage of this etching process is that all substrates were etched without any incubation period or delay. In addition, etching can be enhanced or slowed down by playing with the parameter knobs. By exploring the mechanisms and optimizing the conditions for electron-enhanced etching, the present disclosure aims to overcome the limitations of traditional etching methods and advance the fabrication capabilities in nanotechnology and semiconductor industries.

This disclosure delves into the transformative potential of EE-CVE. The disclosure is based on the intricate interplay between electrons and surface chemistry. By unraveling a mechanism wherein electrons facilitate disilane adsorption through the electron simulated desorption (ESD) of surface hydrogen, this disclosure presents a novel avenue for achieving improved etching. This electron-mediated process propels EE-CVE exclusively in the presence of hydrogen and electrons, adding an extra layer of versatility to the technique.

An aspect of the present disclosure lies in the eradication of nucleation delays. Significantly, the present approach demonstrates exceptional selectivity, favoring, e.g., silicon over silicon dioxide during the etching process. The inherent tunability of electron parameters emerges as a powerful asset, providing precise control over etch rates.

This disclosure not only concerns the capabilities of EE-CVE but underscores its potential to yield, e.g., high-quality, impurity-free silicon films. The versatility in tailoring etching parameters positions EE-CVE as a formidable technique with broad applications in semiconductor device fabrication and materials engineering. As the intricate landscape of advanced electronic materials is navigated, EE-CVE stands at the forefront, poised to make significant contributions to progress in microelectronics and nanotechnology.

Thus, the present disclosure is directed to electron-enhanced processes for electron-enhanced chemical vapor etching (EE-CVE). Si EE-CVE is conducted using only H₂ RBG and electrons. Si etch rates are also significantly higher in the presence of a positive substrate voltage. The secondary electrons attach to H₂ and yield H⁻ and H. The H⁻ is then pulled to the sample stage by the positive sample voltage. The hydrogen removes Si as SiH₄. A wide range of semiconductor materials can be etched at room temperature, such as amorphous Si (a-Si), crystalline Si (c-Si), SiGe, and Ge. The etch rates occur in the order of a-Si > c-Si > SiGe > Ge.

An aspect of the present disclosure is the ability to etch silicon by Si EE-CVE at room temperature (e.g., about 15°C to about 28°C, or more particularly, 15°C to 28°C). In addition, Si EE-CVE occurs without any nucleation delay. In the case of Si EE-CVE, the etching is accomplished with hydrogen only and avoids corrosive halogen precursors. Si EE-CVE also occurs with high selectivity for etching Si in preference to SiO₂ or Si₃N₄. The mechanism of Si EE-CVE is also an aspect of this disclosure. Si EE-CVE is strongly enhanced by a positive substrate voltage. The following mechanism can explain the results: (1) The primary electrons at ~100 eV can generate secondary electrons from the substrate. (2) The lower energy secondary electrons can attach to the H₂ and/or Si₂H₆ reactive background gases in the reactor. (3) The electron attachment then dissociates the reactive background gas through dissociative electron attachment ionization. (4) The negative ions are attracted to the sample by the positive sample stage voltage. (5) The incoming negative ion flux leads to an enhancement in the deposition or etch rates.

An advantage of the present disclosure is that Si EE-CVE occurs at room temperature. This low temperature lowers the thermal budget of semiconductor processing. In addition, the Si EE-CVE occurs solely in the presence of electrons and H₂ reactive background gas. This Si EE-CVE process avoids the use of corrosive halogens such as HF and HCl. Si EE-CVE also proceeds with no nucleation delay depending on the substrate. The EE-CVE process also displays etch selectivity. Amorphous Si etches faster than crystalline Si and SiGe. The SiGe etch rate is higher than crystalline Ge. There is also exceptional selectivity between Si etching and the etching of SiO₂ and Si₃N₄. No etching of SiO₂ and Si₃N₄ was observed in the presence of electrons and H₂ RBG.

Thus, Si EE-CVE can etch silicon at room temperature. This low temperature etching provides many advantages compared with other methods for semiconductor processing. The low temperature etching of silicon can be used during device processing.

This disclosure presents the electron enhanced-chemical vapor etching (EE-CVE) of silicon and other related materials using H₂ as a reactive background gas (RBG) and electrons. Selective EE-CVE has been successfully achieved for silicon in the presence of hydrogen and electrons with a positive voltage on the sample stage. EE-CVE was also achieved for other related materials with relative etch rates a-Si > c-Si > SiGe, Ge > SiO₂. Exceptional selectivity was observed for etching silicon in preference to silicon dioxide (SiO₂). Using electron energies of ~100-150 eV with electron currents of ~200 mA over a surface area of ~4 cm², the etch rates during Si EE-CVE were ~2-6 Å/min. The Si EE-CVE etch rates were shown to be dependent on the electron energies and pressure of the H₂ RBG. SiGe and Ge had lower etch rates, and the etch rate for SiO₂ was negligible. Si EE-CVE was also able to smooth the surfaces Si films deposited using Si EE-CVD. In addition, Si EE-CVE was not accomplished using a D₂ RBG instead of a H₂ RBG. These results support the proposed mechanism for Si EE-CVE where H₂ can produce H⁻ via the reaction H₂ + e⁻ → H₂⁻→ H + H⁻. The positive voltage on the sample stage then pulls the H⁻ negative ions to the silicon sample to react with silicon to produce SiH₄ as an etch product.

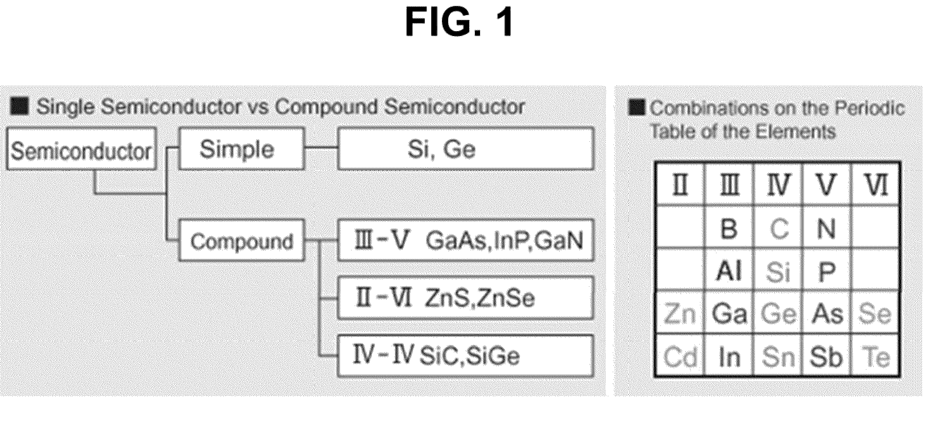

Thus, in addition to electron enhanced-chemical vapor etching of Si, the present disclosure includes electron enhanced-chemical vapor etching of SiGe alloys and Ge. In this regard, the electron enhanced-chemical vapor etching process applies to SiGe alloys with a Ge content ranging from a low content to a high content. For example, the Ge content can range from 15% Ge content to 85% Ge content. However, the Ge content can be 7% Ge content or even 5% Ge content. Further, this etching technique can be extended to any material that has volatile hydrides. This would include all of the elemental and compound semiconductors, such as those shown in FIG. 1.

Moreover, the etch rate difference or selectivity between the amorphous / polycrystalline Si film and the crystalline Si film should be noted. This can enable a low-damage, selective "clean step" to remove defective materials, while leaving the defect-free crystalline materials behind.

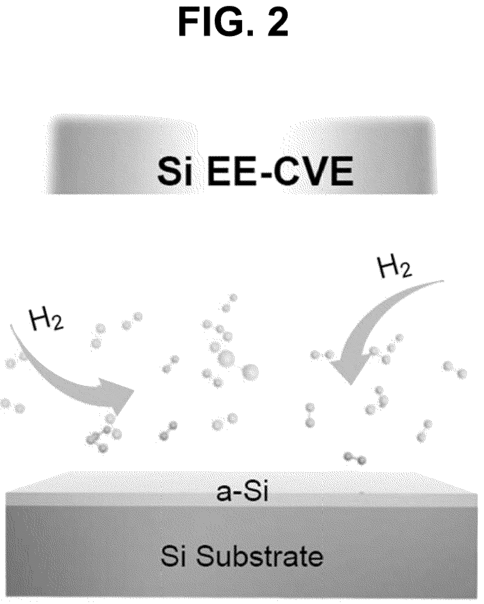

A diagram of one embodiment of the presently disclosed electron-enhanced chemical vapor etching process is shown in FIG. 2. Etch reactions are activated by electron flux reacting with molecules at low temperature, with no direct plasma. Halogen species are not required. The process is BEOL compatible and has been demonstrated at 25°C. The process is a low damage process (no high energy ions) and does not require an etch stop. The process can be turned on / off by switching the electron flow on / off, and replacing H₂ gas with D₂. The process has very high Si selectivity vs. SiO₂ and SiN, and otherwise has some selectivity; with the etch rate trend: a-Si > c-Si > SiGe, Ge > SiO₂. This is in contrast to existing technology in which (1) etch reactions are activated by direct plasma (radicals, ions) or high temperature (>500°C), (2) halogen species and plasma activation are required, (3) the process can be BEOL compatible but is not necessarily BEOL compatible, (4) the process usually leads to substrate damage and requires an etch stop, (5) the process is difficult to control and involves a combination of gas and surface processes, (6) the process has only low to medium selectivity vs. SiO₂ etch, and (7) differentiation between crystalline and amorphous Si is difficult.

As discussed further below, etch of amorphous Si, crystalline Si, SiGe, and Ge thin films using EE-CVE at room temperature with H₂ gas has been demonstrated, as has selective etch of Si vs. SiO₂ and SiN.

### EXAMPLES

Further details and embodiments of the present disclosure will now be explained by way of the following examples of electron enhanced-chemical vapor etching, which do not limit the present disclosure in any way.

### A. Reaction Chamber and Sample Preparation

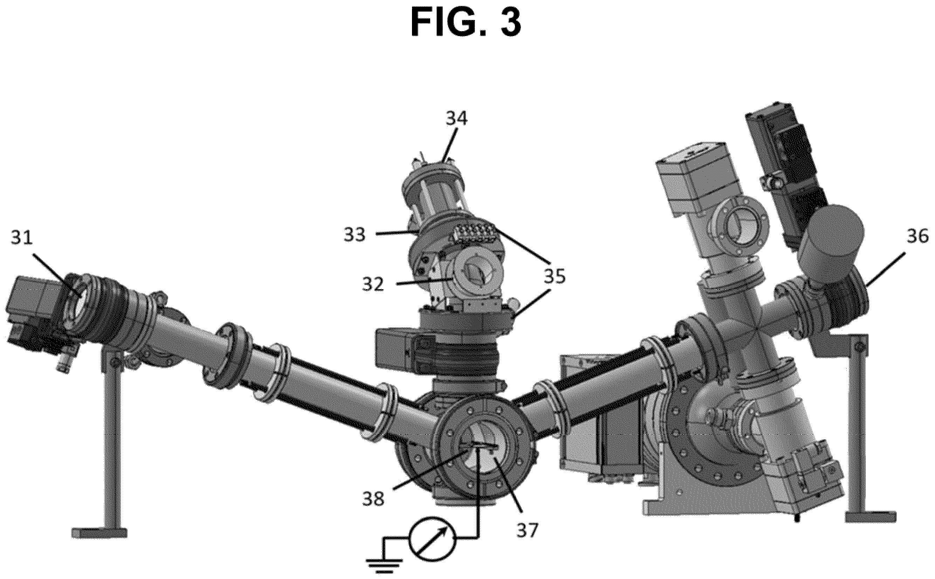

All experiments were conducted within a specialized V-shaped reactor featuring an in-situ (M-2000^{®}) spectroscopic ellipsometer (J.A. Woollam Co., Inc.), set at an incident angle of 70 degrees. This in-situ ellipsometer was used to monitor the growth of Si EE-CVD films, as well as the etching of Si EE-CVE films. A schematic of the V-shaped reactor is provided in FIG. 3, in which the reactor includes iSE source 31, steering coil 32, bias grid 33, hollow cathode 34, collimating coils 35, iSE detector 36, reaction chamber 37, and floating sample stage 38. Details of M2000^{®} ellipsometer operation for electron enhanced thin film processes can be found in Collings, M. A.; Junige, M.; Cavanagh, A. S.; Wang, V.; Kummel, A. C.; George, S. M. Electron-Enhanced Atomic Layer Deposition of Ru Thin Films Using Ru(DMBD)(CO)3 and Effect of Forming Gas Anneal. J. Vac. Sci. Technol. A 2023, 41 (6), 062408.

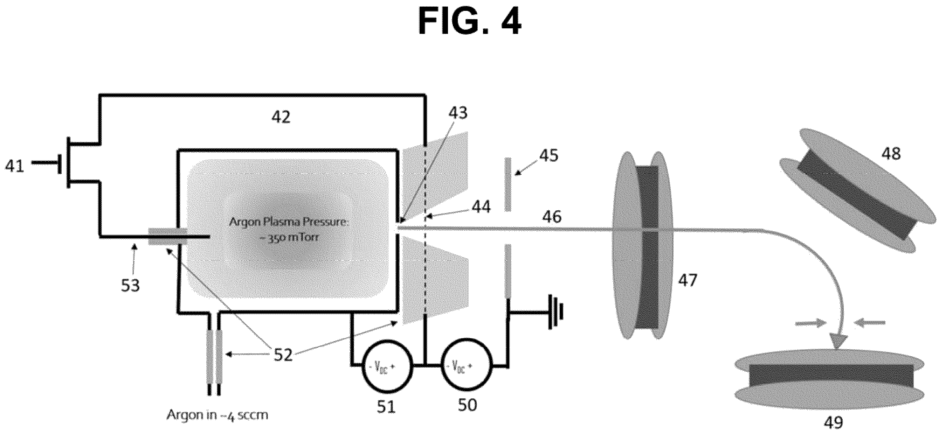

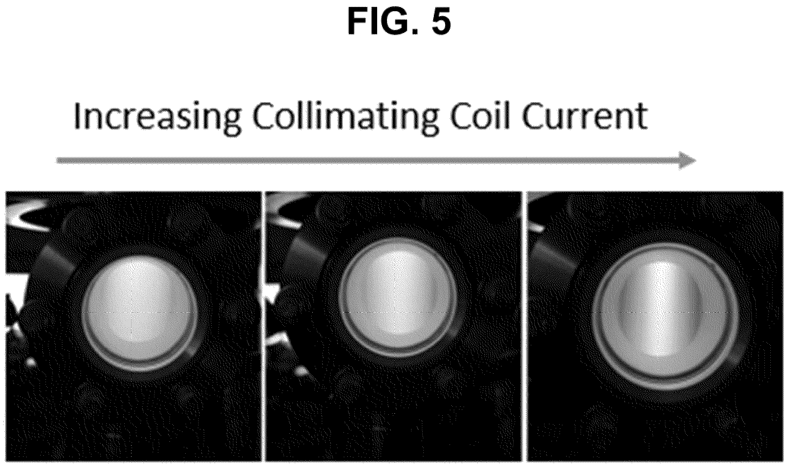

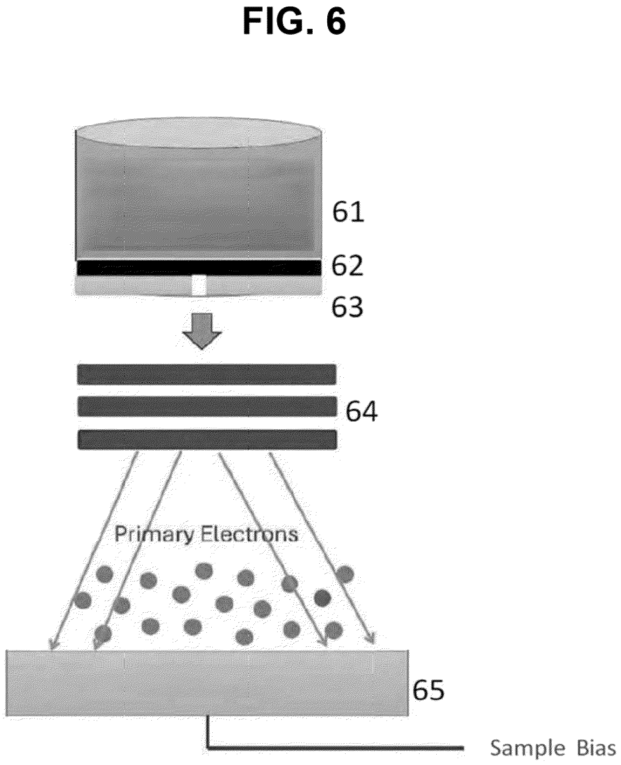

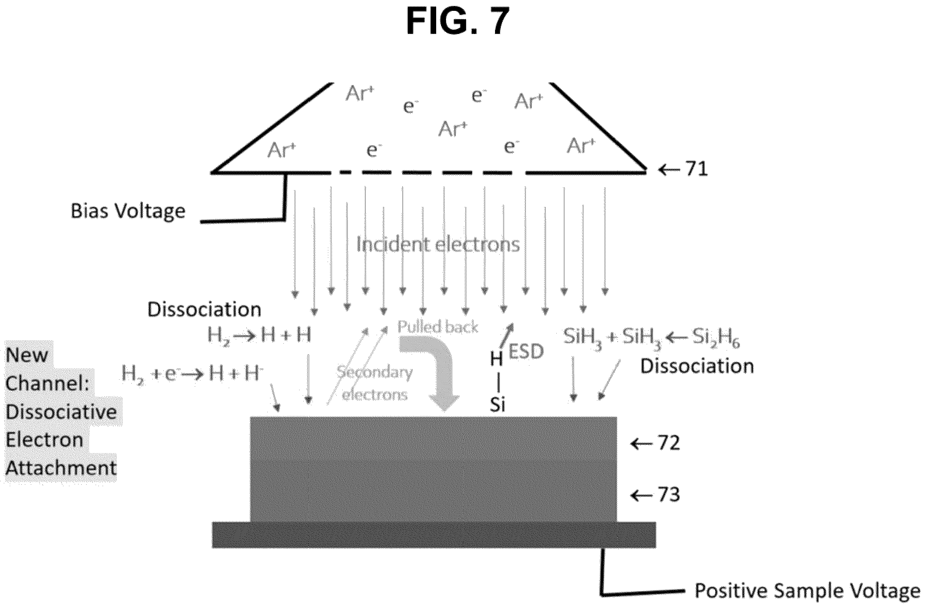

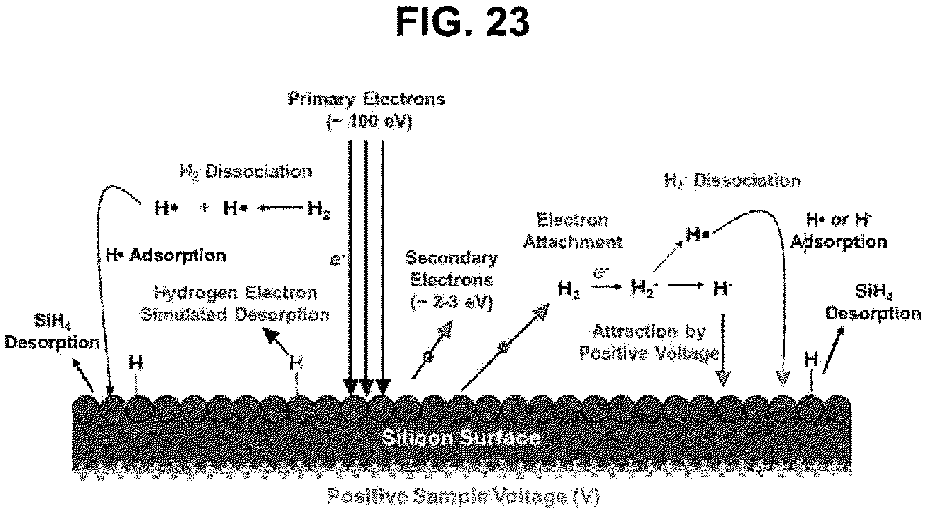

An integral component of the reactor is a hollow cathode plasma electron source (HC-PES), designed to provide the electron beam to the surface. The HC-PES includes a molybdenum (Mo) aperture, approximately 2 mm in diameter, serving as an exit point for electrons. Additionally, a bias grid is incorporated, applying a positive voltage relative to the hollow cathode walls. This setup enables electron emission from the HC-PES, subsequently accelerated and directed towards the sample surface through a series of electron optics, including steering and collimating coils. FIG. 4 shows a diagram of the hollow cathode operation, in which the diagram includes MOSFET 41, hollow cathode 42, aperture 43, bias grid 44, chamber ground 45, electron beam 46, collimating coil 47, steering coil 48, collimating coil 49, acceleration power supply 50, plasma power supply 51, dielectric 52 and secondary anode 53. FIG. 5 shows increasing collimating coil current, which is a parameter that can affect electron enhanced processes. Other parameters which can affect electron enhanced processes include steering coil current, bias grid voltage and electron energy, Si₂H₆ pressure, H₂ reactive background gas pressure, and secondary electron yield. FIG. 6 is a schematic diagram showing the hollow cathode generating primary electrons in an embodiment of the present disclosure, in which the diagram includes hollow cathode 61, bias grid 62, Mo aperture 63, electron optics 64, and substrate 65. FIG. 7 shows various pathways for electron-enhanced processing in an embodiment of the present disclosure, in which the figure includes bias grid 71, Si layer 72, and SiO₂ layer 73. In FIG. 7, bias voltage defines energy of electrons coming from HC-PES; sample voltage adds extra electron energy and collects secondary electrons emitted as a result of incident electrons; H₂ and electrons are present at all times, and Si₂H₆ is pulsed into the reactor; electrons dissociate H₂ and Si₂H₆, and electron stimulated desorption (ESD) of H from the surface occurs; and secondary electrons may attach to H₂ and dissociate H₂ according to H₂ + e⁻ → H + H⁻, with sample voltage pulling H⁻ to the surface for reaction. FIG. 23 is a schematic diagram for electron-enhanced Si etching with H₂ reactive background gas for an exemplary embodiment of the present disclosure. Comprehensive details regarding the reactor design and operation can be found in Sobell, Z. C.; Cavanagh, A. S.; Boris, D. R.; Walton, S. G.; George, S. M. Hollow Cathode Plasma Electron Source for Low Temperature Deposition of Cobalt Films by Electron-Enhanced Atomic Layer Deposition. J. Vac. Sci. Technol. Vac. Surf. Films 2021, 39 (4), 042403 and Collings et al. set forth above.

Electrons were generated utilizing an argon (Ar) plasma within the HC-PES, sourced from Airgas with 99.999% purity. Ar flow through the hollow cathode cavity was 3 sccm controlled by a mass flow controller (MFC) (e.g., MKS, 14 sccm range). A bias grid maintained at a voltage of -50 V was employed to regulate the energy of electrons emitted from the HC plasma. The incident electron current on the substrate and sample holder was approximately 200 mA. To make the accurate current measurements, while taking into account the secondary electrons and negative ions (as a result of dissociative electron attachment), a positive sample bias of + 90 V was applied on the stage. Sample current was measured by a multimeter (Keithley, DMM7510 7.5 Digit Multimeter) probe affixed to the sample stage.

Various substrates were used for Si EE-CVE experiments. Si (100) of SOI was used as a crystalline Si substrate. This SOI substrate has a device thickness of 700 A, with a box layer thickness of 20000 A. Si EE-CVD films grown at ambient conditions were grown and used as amorphous Si substrates, with a thickness of ~350 Å. Ge rich- SiGe was another substrate used for EE-CVE experiments, containing 15 % Si and 85 % Ge. The layer thickness was ~1000 Å. Crystalline germanium (Ge (100)) on Si was also used for the EE-CVE experiments with a thickness of ~1000 Å. EE-CVE process consists of H₂ RBG and electrons continuously present in the chamber.

### B. Precursors and Reactants

During EE-CVE experiments, electrons were supplied continuously, and the reactor had a constant flow of 3 sccm hydrogen (H₂, 99.999, Airgas) as the reactive background gas (RBG) controlled by an MFC (MKS, 50 sccm range). The pressure in the chamber with only H₂ RBG flowing was <3 mTorr. Prior to the experiments, all substrates were pre-cleaned by rinsing it with acetone, isopropyl alcohol (IPA) and water, in the same order and dried with N₂.

### C. Results and Discussion

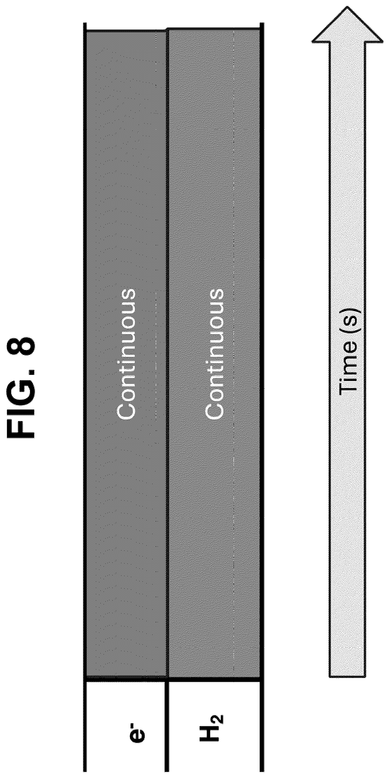

FIG. 8 presents a schematic diagram illustrating the Si EE-CVE process, where electrons and H₂ RBG are continuously introduced into the chamber. And because of a primary beam ~150 eV or more, secondary electrons are emitted from the surface, which further participate in the reaction kinetics.

In an embodiment of the process of the present disclosure, a primary electron beam with an energy of approximately 150 eV is directed towards the sample surface, causing the emission of secondary electrons. Some secondary electrons, with energies between 3-4 eV, are recollected at the surface due to the positive bias present on the sample surface. The rest of these secondary electrons undergo dissociative electron attachment to H₂ molecules, resulting in the formation of H⁻ ions and H radicals. Due to the influence of the positive sample bias present on the sample surface, these H⁻ ions accelerate towards the sample surface and assist in etching. H₋ is expected to react with silicon to produce SiH₄ or possibly higher silanes such as Si₂H₆ as the reaction product.

H radicals are already being utilized and have a very promising etch rate for amorphous hydrogenated Si. Some researchers have reported on H radical etching phenomenon of a-Si:H. Nozaki et al (Nozaki, H.; Sakuma, N.; Ito, H. Mercury-Sensitized Hydrogen Radical Photoetching of Undoped Hydrogenated Amorphous Silicon and Crystalline Silicon. Jpn. J. Appl. Phys. 1989, 28 (10A), L1708) and Nishikawa et al (Nishikawa, O.; Maeda, K.; Ohtani, Y.; Watanabe, M.; Tanaka, K.; Sekine, T.; Iwatsuki, M.; Aoki, S.; Itoh, J.; Yamanaka, K. Atomic Level Analysis of Electron Emitter Surfaces by the Scanning Atom Probe. Appl. Surf. Sci. 1999, 146 (1-4), 398-407) examined H radical photoetching and active plasma etching. The etch rates in these studies were observed to be 0.06 um/min. Nagayoshi et al. (Nagayoshi, H.; Yamaguchi, M.; Kamisako, K.; Tarui, T. H. High-Rate Selective Etching of a-Si:H Using Hydrogen Radicals. Jpn. J. Appl. Phys. 1994, 33 (5A), L621) developed a high-rate selective etching method of hydrogenated amorphous Si using the same H radicals with an etch rate of 2.7 um/min, at 50 C using a microwave hydrogen afterglow method. Hydrogen radicals go into the Si substrate and break the Si-Si bonds, converting them to Si-H bonds, which further result in forming the volatile species such as SiH₄ and Si₂H₆, which are eventually removed from the surface, resulting in Si etching.

The impact of positive sample bias was investigated in detail for Si EE-CVD as discussed above. High growth rates in the presence of positive sample bias on the surface were observed. Keeping the same concept, Si EE-CVE was also investigated using to understand the effect of sample bias on etching. Si EE-CVE was also investigated both with and without a sample bias of + 90 V. Notably, when the sample bias was turned on, the etch rate exhibited a substantial increase compared to when the sample bias was absent. The application of sample bias significantly influences the etch rate during Si EE-CVE. With the sample bias turned on, the etch rate is notably higher than when the bias is off.

This phenomenon can be attributed to the effect of the applied bias on secondary electrons. When the sample bias is applied, secondary electrons are drawn back towards the substrate. These secondary electrons then dissociatively attach to H₂ molecules, forming negatively charged hydrogen ions (H⁻). These hydrogen ions are accelerated towards the Si surface due to the applied sample bias, leading to an enhanced etch rate. Si EE-CVE was performed with and without sample bias.

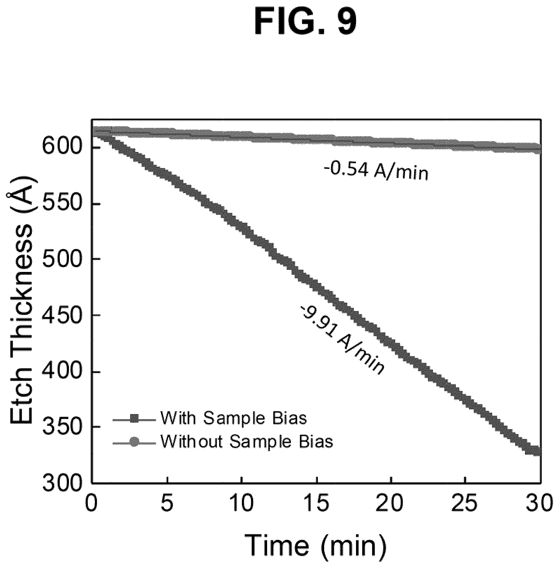

FIG. 9 illustrates the change in etch thickness vs time of Si EE-CVE with and without the application of sample bias. In the absence of sample bias, the etch rate is approximately 0.54 A/min. However, with a positive sample bias of + 90 V applied, the etch rate significantly increases to approximately 9.9 A/min. This significant difference underscores the substantial impact of sample bias on the etching process during Si EE-CVE.

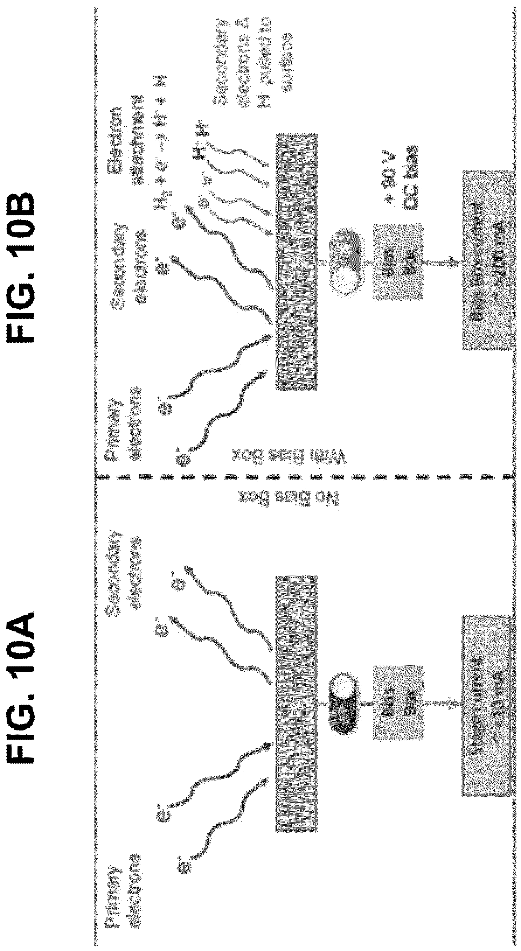

The process schematic for Si EE-CVE in the absence and presence of positive sample bias is displayed in FIGS. 10A and 10B, respectively. This schematic shows that when a primary electron beam strikes a surface, secondary electrons are emitted. Since these primary electrons have an energy of ~3-4 eV, they go to ground from walls of the reactor or finding other paths to ground. However, when a positive sample bias is present on the sample stage, some of these secondary electrons are pulled back to the surface, while other take part in dissociative electron attachment to the H₂ molecules. This results in H⁻ ion and H radicals, which further enhance the etch process.

The present disclosure differentiates over other processes in the, e.g., the positive sample bias can be used to attract secondary electrons, which leads to more reactions, which results in faster etching.

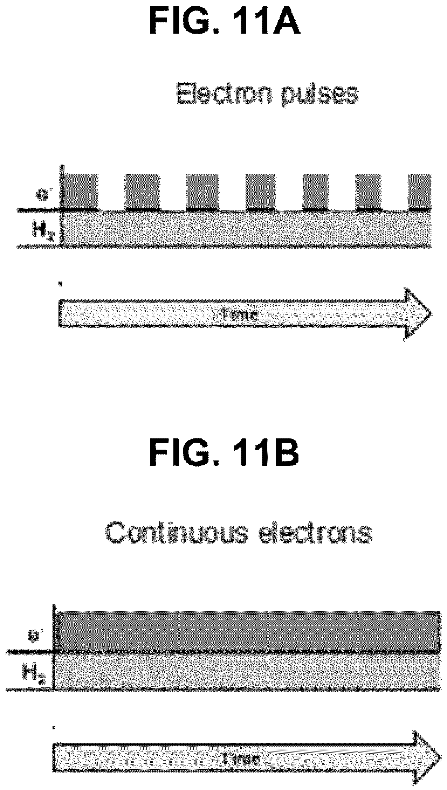

Si EE-CVE etch process was further elucidated and observed for electron pulses and continuous electrons. FIGS. 11A and 11B show the schematic diagrams for the Si EE-CVE process for electron pulses and continuous electrons. Essentially, the electrons dosage time is similar in both cases. During electron pulses, the pause during the pulses is due to the ellipsometry shutter turn on and off time, which is ~10 s, while during continuous electrons, real-time in-situ ellipsometry was involved.

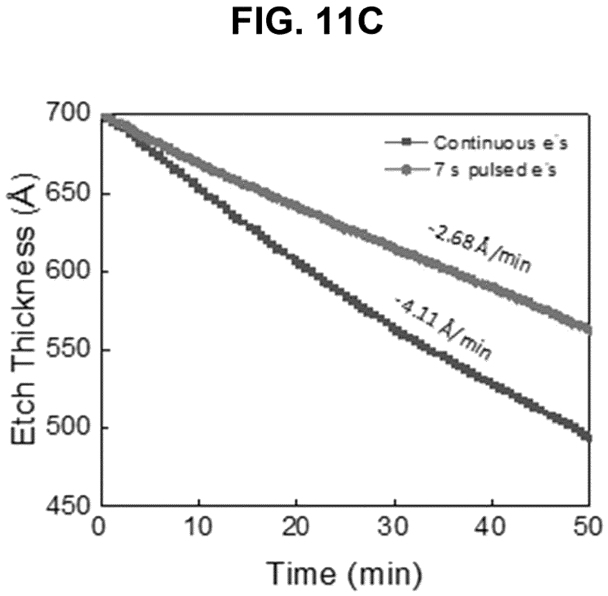

FIG. 11C shows the etch thickness of Si (100) with time. Etch seems continuous, without any delay, and is linear throughout. The etch rate for 7 s electron pulses was observed to be ~2.68 A/min, while for continuous electrons, it was observed to be a little higher i.e. ~4.11 A/min. Slightly lower etch rate for 7 s electron pulses can be explained by the ellipsometry measurement pause.

The role of various parameters which affect the electron enhanced etching of Si and other dielectric materials was further investigated. Referring back to FIG. 6, that figure is a diagram explaining how different parameters play a role in the experiments and how the etch thicknesses can be controlled by just controlling these parameters. The parameters which affect the etch process are the primary electron beam energy, type of primary beam, whether the electron beam is collimated or diffuse, and changing the collimating coil current changes the etch rates. Hydrogen flux is a another parameter to control etching. The sample bias on the surface and bias grid voltage also affects the etch rates of Si and other materials during electron enhanced processing. These parameters are highlighted in red in the FIG. 6.

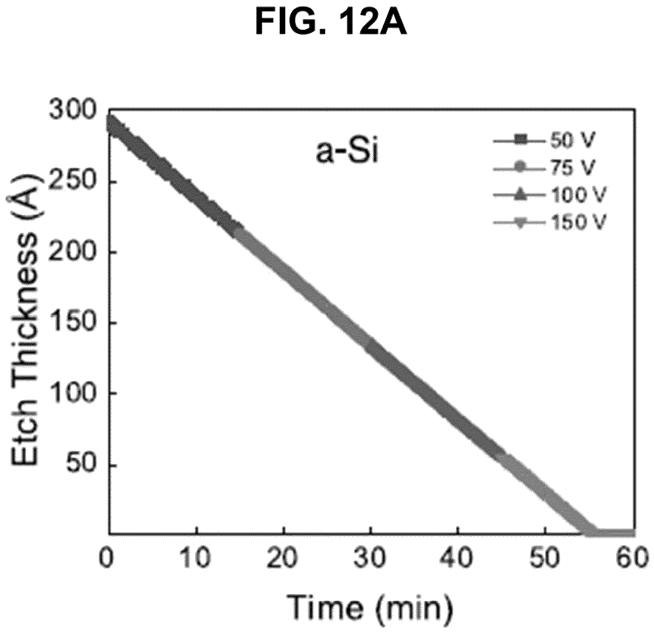

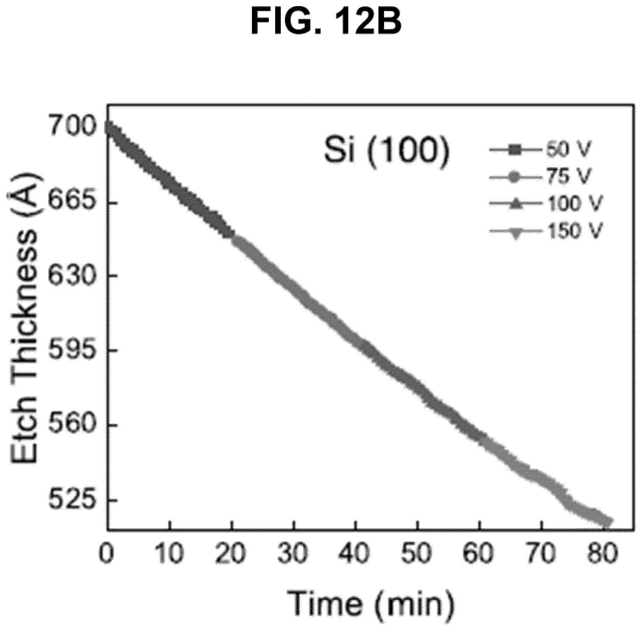

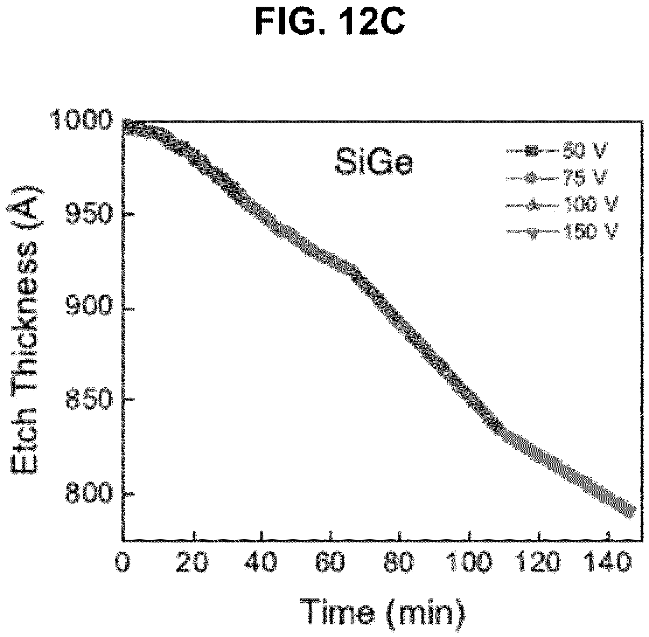

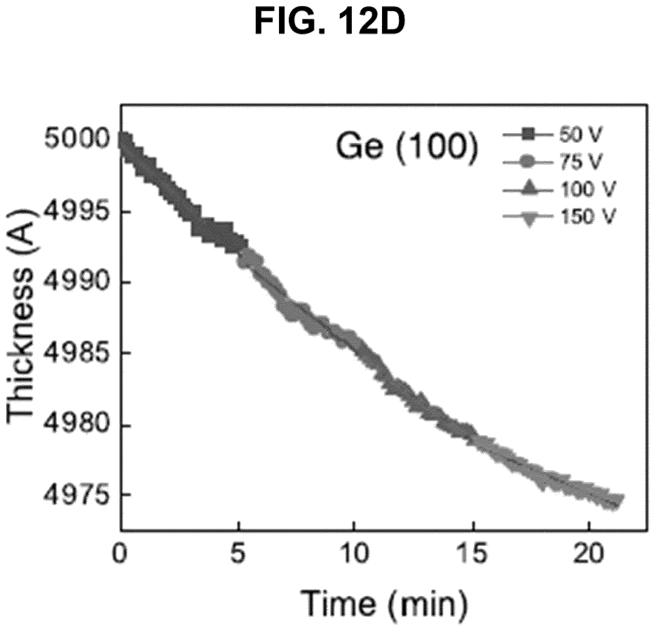

Si EE-CVD was performed at these various electron parameters and the etch rate was measured by keeping the conditions constant. In FIGS. 12A-12D, EE-CVE results are depicted for various semiconductor materials: a-Si (FIG. 12A), c-Si (FIG. 12B), SiGe (FIG. 12C), and c-Ge (FIG. 12D) under different grid bias voltages, while keeping the rest of the conditions constant.

Notably, FIG. 12A illustrates the EE-CVE of a-Si, demonstrating a linear etch profile. At grid bias voltages of 50, 75, and 100 V, the etch rate remains relatively constant at approximately 5.25 A/min. However, at 150 V grid bias, the etch rate decreases to around 4.06 A/min.

FIG. 12B illustrates the EE-CVE of c-Si under similar conditions while varying the grid bias voltages. Similar to the behavior observed with a-Si, the etch rate shows a slight decrease as the grid bias voltage increases. The etch profile remains linear at each grid bias voltage. Specifically, at 50 V, the etch rate is approximately 2.6 A/min, which reduces to 2.39 A/min at 75 V. The rate then experiences a slight further reduction to around 2.29 A/min at 100 V. Finally, at 150 V, the etch rate decreases to approximately 1.9 A/min.

In FIG. 12C, the etch rates are presented for SiGe under identical conditions, with varying grid bias voltages. Notably, the etch rate exhibits remarkable consistency across different grid bias voltages. At 50 V, the etch rate is approximately 1.2 A/min, maintaining this value consistently. Similarly, at 100 V, the etch rate remains stable, hovering around 1.22 A/min. The etch rate further drops to 1.14 A/min at 150 V, keeping the etch rate linear. This observation suggests that SiGe demonstrates a relatively stable etch rate across a range of grid bias voltages, with only minor fluctuations observed at higher voltages.

In FIG. 12D, EE-CVE behavior of c-Ge is depicted, showcasing trends analogous to those observed in the etching profiles of a-Si, c-Si, and SiGe in FIGS. 12A, 12B, and 12C, respectively. Consistent with the observed pattern, the etch rate of c-Ge exhibits a slight decrease with increasing bias grid voltage. Specifically, at 50 V, the etch rate is approximately 1.51 A/min. This rate decreases to around 1.25 A/min at 100 V. Finally, at 150 V, the etch rate reduces notably to about 0.69 A/min.

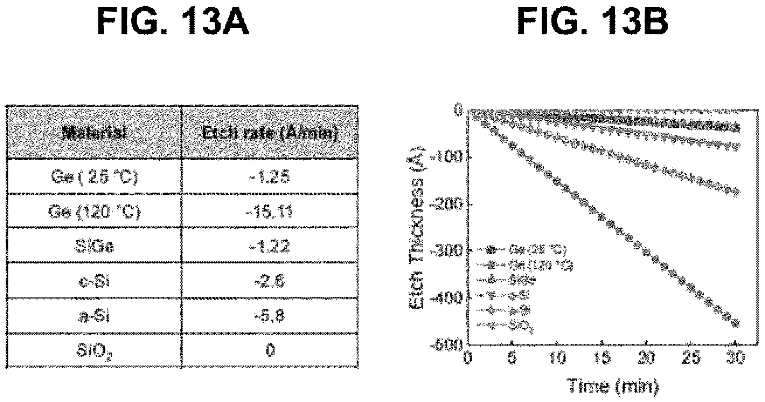

Etch selectivity of various substrates at 100 V of grid bias is shown in FIG. 13B. The results are summarized in FIG. 13A. The order for etch rate for different substrates is a-Si > c-Si > SiGe, Ge > SiO₂. Amorphous Si etches faster than crystalline Si, with etch rates of 5.8 A/min and 2.6 A/min, respectively. SiGe and crystalline Ge etch slower than amorphous and crystalline Si, with nearly equivalent etch rates of 1.22 A/min and 1.25 A/min, respectively. In addition, no etching was observed for SiO₂. This provides a 100 % selective etch process for a-Si and SiO₂.

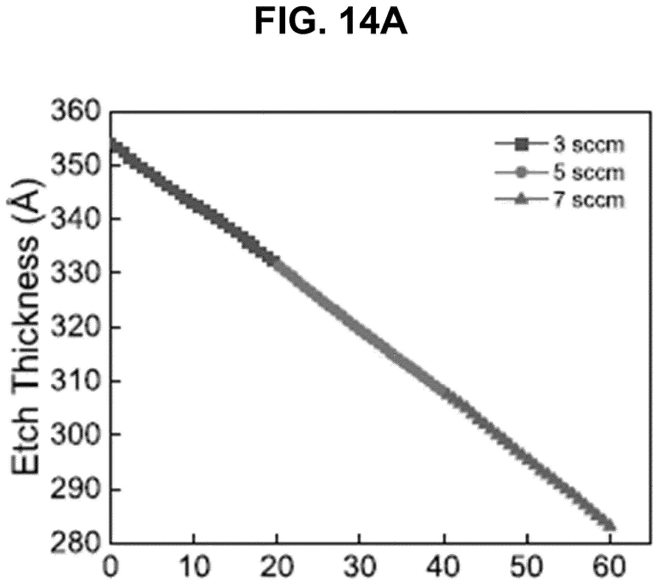

Etch trends are further explored by keeping the grid bias voltage constant to 50 V and increasing the H₂ RBG flux. FIG. 14A shows the EE-CVE of a-Si. The etch rate with increase in H₂ flux increases slightly. At 3 sccm, the etch rate is ~1.09 A/min, which slightly increases to 1.17 A/min, with an increase in H₂ flux to 5 sccm. The etch rate further increases to 1.29 A/min for an H₂ flux of 7 sccm. This is unexpected because one would believe that the etch rate would increase with increase in H₂ flux. However, the changes in etch rate are not significant.

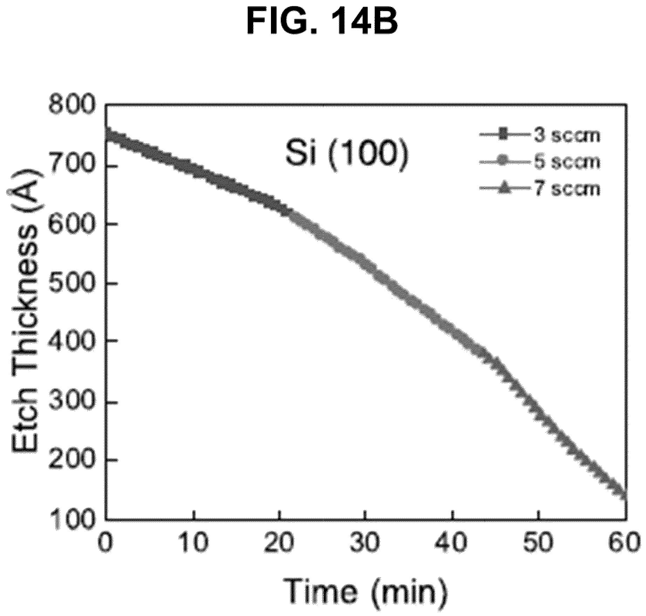

In FIG. 14B, EE-CVE of c-Si is shown, demonstrating a notable correlation between etch rates and the H₂ flow rate. As the H₂ flow increases, the etch rates exhibit a clear upward trend. Specifically, at a flow rate of 3 sccm, the etch rate measures approximately 6.11 A/min. This rate significantly escalates to around 10.78 A/min when the flow is increased to 5 sccm, and further rises to approximately 14.75 A/min at 7 sccm. Notably, the etch slopes remain linear within each regime. These results reveal the relationship between H₂ flow rate and etch rates observed in the EE-CVE of c-Si. There is a direct impact of varying H₂ flow rates on the etching process.

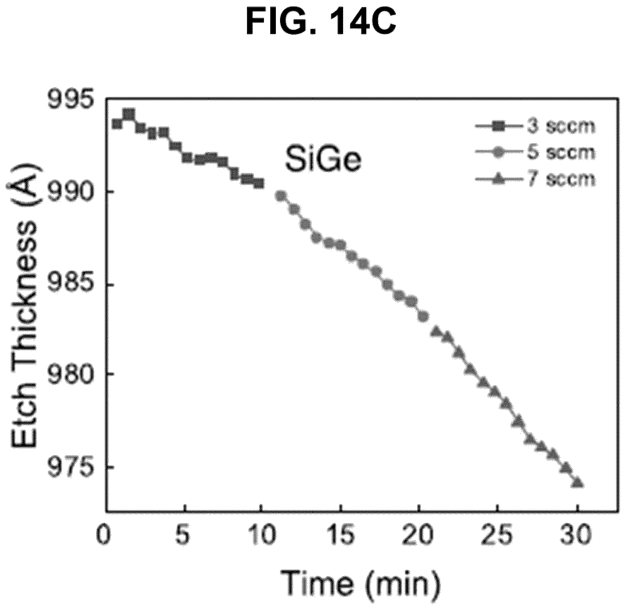

FIG. 14C illustrates the etch rates for SiGe, revealing intriguing disparities compared to a-Si and c-Si, despite consistent etch trends. Notably, SiGe exhibits notably lower etch rates than a-Si and c-Si across various H₂ flow rates, while still maintaining consistent trends. At H₂ flow rate of 3 sccm, the etch rate for SiGe is approximately 0.40 A/min, demonstrating a slight increase to around 0.67 A/min at 5 sccm, and further rising to about 0.93 A/min at 7 sccm. The etch slopes remain linear within each flow rate regime. SiGe has lower etch rates than c-Si and also varies slightly with H₂ flow rates.

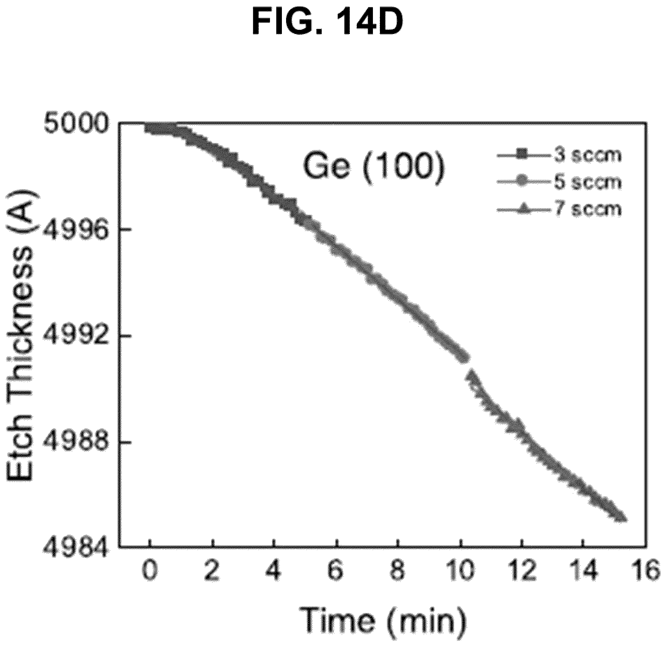

Additionally, the investigation extends to the etch rates of c-Ge with varying H₂ flow rates, as shown in FIG. 14D. Notably, at 3 sccm of H₂, the etch rates are approximately 0.75 A/min, which incrementally rise to around 1 A/min at 5 sccm. Subsequently, a slight further increase is observed, reaching approximately 1.1 A/min with 7 sccm of H₂. Consistent with the trends observed in previous materials, the etch rates increase proportionally with the augmentation of H₂ flow. Furthermore, akin to prior observations, the etch slopes maintain consistency within each specific etch regime.

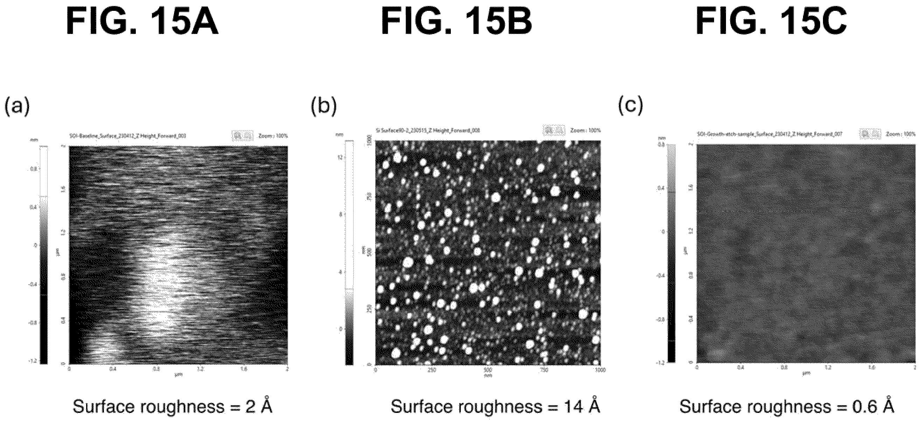

That silicon etching actually reduces the surface roughness was also observed. FIGS. 15A-15C show the atomic force microscopy (AFM) roughness of (a) pristine SOI wafer; (b) EE-CVD grown Si film (10 nm); and (c) the same Si EE-CVD film after etching. Pristine SOI wafer has a surface roughness of ~2 A, as shown in FIG. 15A. The surface roughness increased to 14 A, after a 10 nm Si EE-CVD film was formed, as can be seen in FIG. 15B. The film roughness was further characterized using AFM after etching the 10 nm Si EE-CVD grown film. The film roughness drastically reduces to 0.6 A after etching, as shown in FIG. 15C. This film roughness is significantly lower than the starting Si wafer. These AFM characterizations demonstrate that Si EE-CVE can smooth the surface roughness.

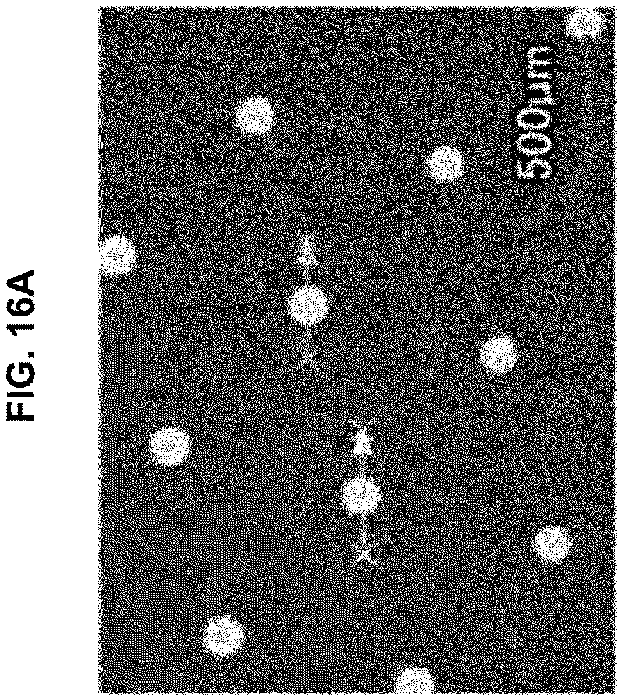

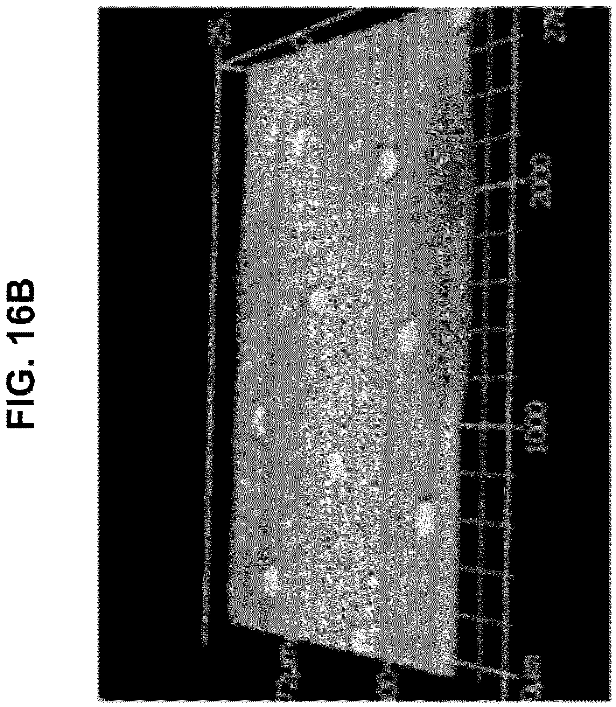

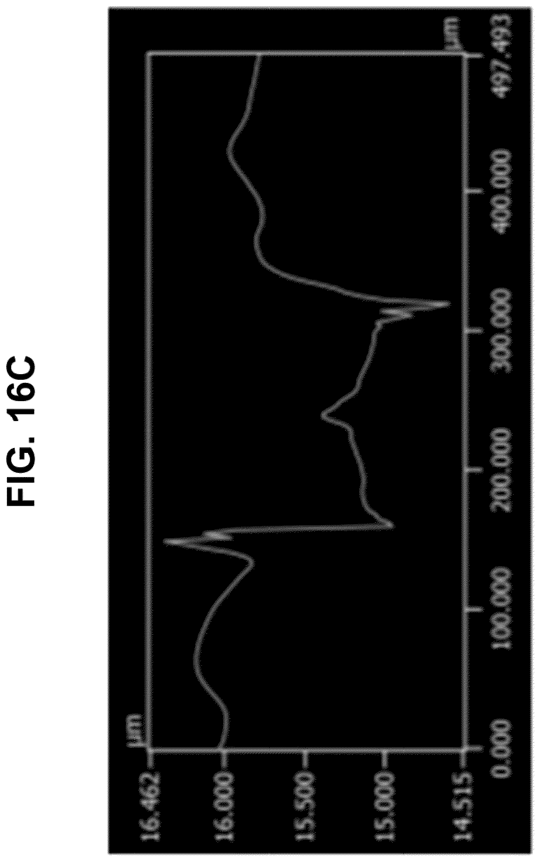

FIGS. 16A-16C show the etching of Si using EE-CVE through a stainless-steel mesh mask. The mesh had pores of ~600 µm diameter and a thickness of ~3 mm. FIG. 16A shows the topographical image of the SOI surface (70 nm Si (100) on top) after 15 mins of Si EE-CVE in the presence of H₂ RBG and electrons. FIG. 16B shows a 3D image from the surface profilometer, where the etch pits are visible. The depth and the diameter of the etch pits can also be observed in FIG. 16C.

The etch pits are about 1 um deep with a diameter of ~150 µm. The diameters of the etch pits are much smaller than the actual pore size of ~600 µm in the stainless steel mesh. The smaller etch pits could result from the attenuation of the H radicals on the sidewalls of the stainless-steel mesh. The openings in the stainless-steel mesh have an aspect ratio of 3 mm/~600 µm = 5:1. Hydrogen radicals or H⁺ ions formed from H₂ may be attenuated as they travel through the pores in the stainless-steel mesh with a 5:1 aspect ratio.

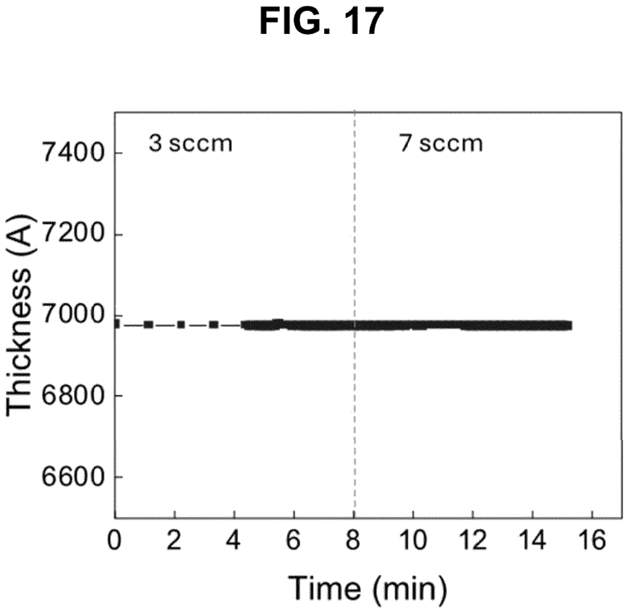

Si EE-CVE was also attempted with D₂ as the RBG. D₂ is very similar to H₂ chemically. Using D₂ for Si EE-CVE determines if there is an isotope effect on the Si EE-CVE process. FIG. 17 shows the Si EE-CVE using D₂ at 3 sccm and 7 sccm of D₂. Surprisingly, D₂ did not etch the silicon. The silicon film thickness stayed the same with no trace of etching.

One possibility why D₂ may not be etching silicon may be related to the different dissociative electron attachment (DEA) cross sections for H₂ and D₂. The peak of the DEA cross-section for H₂ is 3.4 eV. In contrast, the peak of the DEA cross-section for D₂ is 14 eV. Because most of the secondary electrons are <5 eV, the secondary electrons may not have enough energy to interact with D₂. Therefore, H₂ can produce H⁻ via the reaction H₂ + e⁻ → H₂⁻ → H + H⁻. In contrast, the reaction D₂ + e⁻ → D₂⁻ → D + D⁻ may not occur to form D⁻ by dissociative electron attachment.

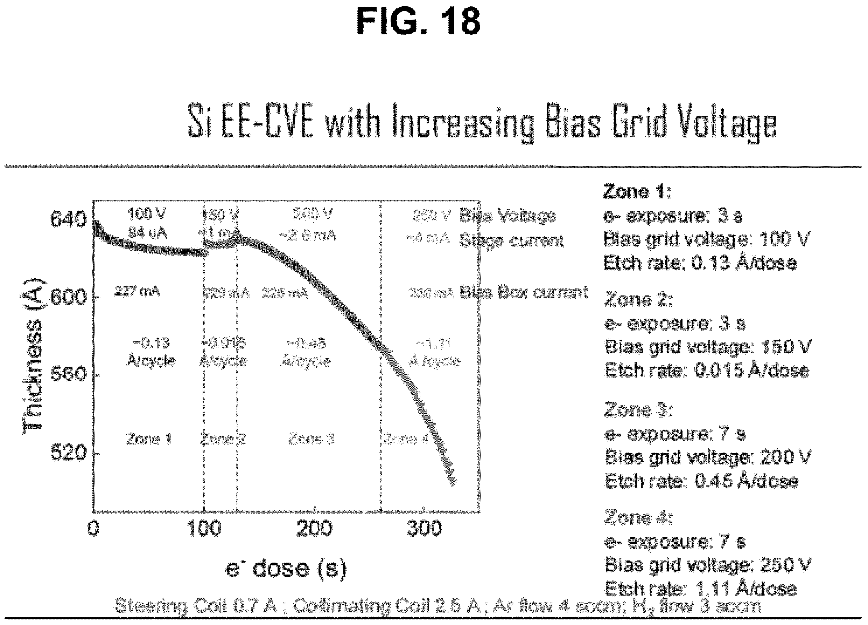

FIG. 18 shows an exemplary embodiment of the present disclosure for Si EE-CVE with increasing bias grid voltage.

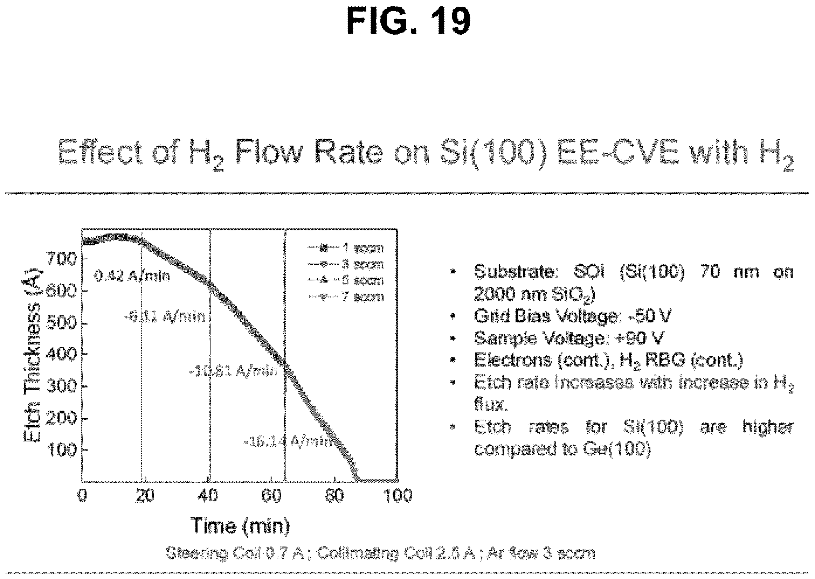

FIG. 19 shows the effect of H₂ flow rate on Si(100) EE-CVE with H₂ for an exemplary embodiment of the present disclosure.

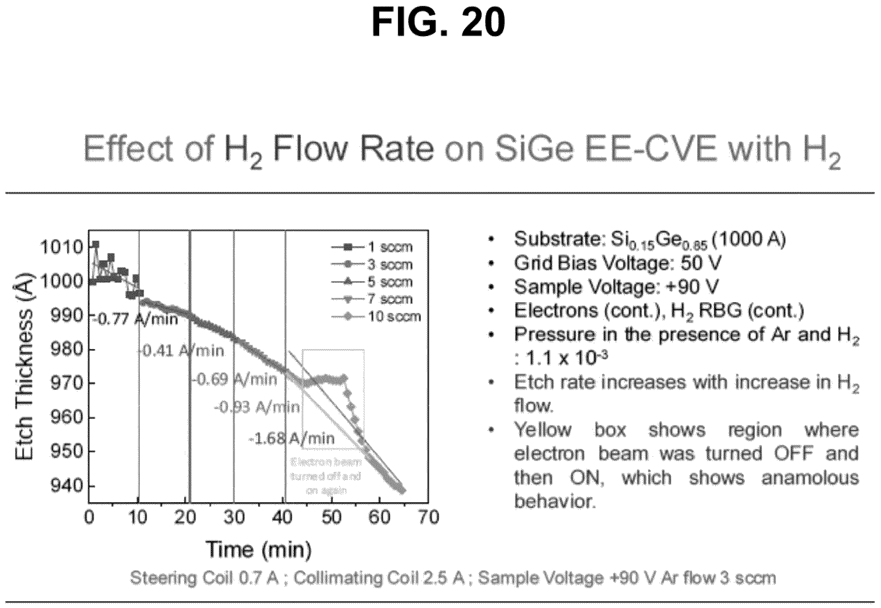

FIG. 20 shows the effect of H₂ flow rate on SiGe EE-CVE with H₂ for an exemplary embodiment of the present disclosure.

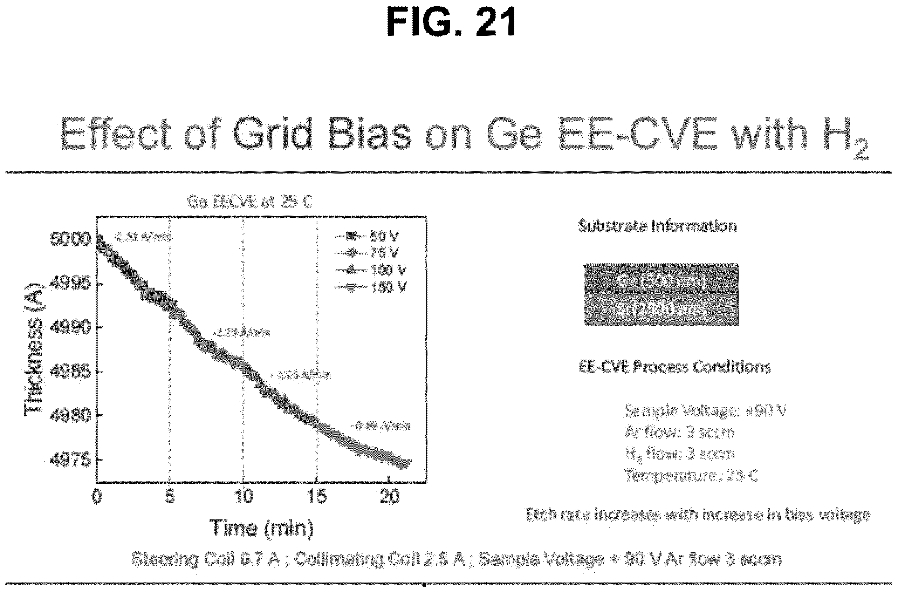

FIG. 21 shows the effect of grid bias on Ge EE-CVE with H₂ for an exemplary embodiment of the present disclosure.

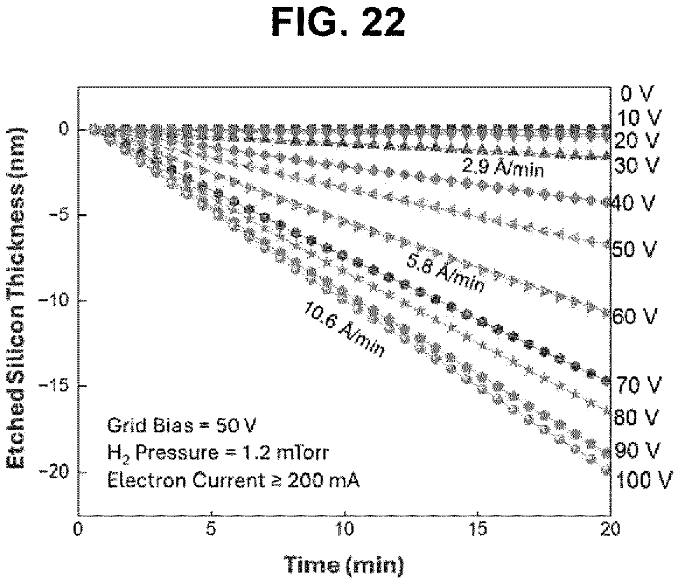

FIG. 22 is a graph showing etching of amorphous silicon at different positive sample voltages vs. time for an exemplary embodiment of the present disclosure.

### D. Conclusions

The EE-CVE of silicon and other related materials was accomplished using H₂ as a reactive background gas (RBG) and electrons. Selective EE-CVE was successfully achieved for silicon in the presence of hydrogen and electrons with a positive voltage on the sample stage. EE-CVE was also achieved for other related materials with relative etch rates a-Si > c-Si > SiGe, Ge > SiO₂. Exceptional selectivity was observed for etching silicon in preference to silicon dioxide (SiO₂).

Using electron energies of ~100-150 eV with electron currents of ~200 mA over a surface area of ~4 cm², the etch rates during Si EE-CVE were ~2-6 Å/min. The Si EE-CVE etch rates were shown to be dependent on the electron energies and pressure of the H₂ RBG. For example, in an embodiment of the present disclosure, the electron energy was ~140-240 eV, and the RBG pressure was <3 mTorr. SiGe and Ge had lower etch rates and the etch rate for SiO₂ was negligible. Si EE-CVE was also able to smooth the surfaces Si films deposited using Si EE-CVD.

In addition, Si EE-CVE was not accomplished using a D₂ RBG instead of a H₂ RBG. These results support the proposed mechanism for Si EE-CVE where H₂ can produce H⁻ via the reaction H₂ + e⁻ → H₂⁻ → H + H⁻. The positive voltage on the sample stage then pulls the H⁻ negative ions to the silicon sample to react with silicon to produce SiH₄ as an etch product.

The foregoing is illustrative of exemplary embodiments and is not to be construed as limiting the disclosure. Although a few exemplary embodiments have been described, those skilled in the art will readily appreciate that many modifications are possible in the above embodiments without materially departing from the disclosure.

## Claims

1. A method for electron-enhanced chemical vapor etching of a film, comprising:
cleaning and drying (S10) a substrate having the film thereon,
introducing (S20) a reactive background gas into a reaction chamber containing the substrate,
applying (S30) electrons to the reaction chamber to dissociate the reactive background gas and create reactive species,
etching (S40) the film on the substrate by reacting the reactive species with the film, wherein the substrate has a positive substrate voltage, and
removing (S50) etched material from the reaction chamber, leaving behind a pattern or structure on the substrate.

2. The method of claim 1, wherein the film is an amorphous silicon film.

3. The method of claim 1, wherein the film is a crystalline silicon film.

4. The method of claim 1, wherein the film is a germanium film.

5. The method of claim 1, wherein the film is a silicon germanium film.

6. The method of claim 5, wherein the silicon germanium is SiₓGe₁₋ₓ, wherein 0.15≤x≤0.85.

7. The method of claim 5, wherein the silicon germanium is SiₓGe₁₋ₓ, wherein 0.85<x<1.

8. The method of claim 1, wherein the substrate having the film thereon is (i) a silicon dioxide substrate having a silicon film thereon or (ii) a silicon nitride substrate having a silicon film thereon.

9. The method of any one of claims 1 to 8, wherein the reactive background gas is hydrogen.

10. The method of any one of claims 1 to 9, wherein the etching is conducted at a temperature of 15°C to 28°C.

11. The method of any one of claims 1 to 10, wherein the positive substrate voltage is up to 100 V.
